(19) Europäisches Patentamt
European Patent Office
Office européen des brevets

(11) **EP 1 252 660 B1**

(12) **EUROPÄISCHE PATENTSCHRIFT**

(45) Veröffentlichungstag und Bekanntmachung des Hinweises auf die Patenterteilung:
**26.08.2009 Patentblatt 2009/35**

(51) Int Cl.:
***H01L 29/73*** *(2006.01)*   ***H01L 29/08*** *(2006.01)*

(21) Anmeldenummer: **01949066.3**

(22) Anmeldetag: **24.01.2001**

(86) Internationale Anmeldenummer:
**PCT/EP2001/000745**

(87) Internationale Veröffentlichungsnummer:
**WO 2001/057916 (09.08.2001 Gazette 2001/32)**

(54) **BIPOLARTRANSISTOR**

BIPOLAR TRANSISTOR

TRANSISTOR BIPOLAIRE

(84) Benannte Vertragsstaaten:
**AT BE CH CY DE DK ES FI FR GB GR IE IT LI LU MC NL PT SE TR**

(30) Priorität: **31.01.2000 DE 10004111**

(43) Veröffentlichungstag der Anmeldung:
**30.10.2002 Patentblatt 2002/44**

(73) Patentinhaber: **Infineon Technologies AG**
**81669 München (DE)**

(72) Erfinder:
• **AUFINGER, Klaus**
**85521 Ottobrunn (DE)**
• **ZEILER, Markus**
**93152 Nittendorf-Undorf (DE)**
• **BÖCK, Josef**
**81827 München (DE)**

(74) Vertreter: **Zimmermann & Partner**
**Postfach 330 920**
**80069 München (DE)**

(56) Entgegenhaltungen:
**US-A- 4 680 608**   **US-A- 5 455 186**
**US-A- 5 675 175**

• **PATENT ABSTRACTS OF JAPAN vol. 010, no. 179 (E-414), 24. Juni 1986 (1986-06-24) & JP 61 029173 A (SANYO ELECTRIC CO LTD;OTHERS: 01), 10. Februar 1986 (1986-02-10)**

## Beschreibung

Die vorliegende Erfindung betrifft einen Bipolartransistor.

Bipolartransistoren sind im allgemeinen aus zwei nahe beieinander liegenden pn-übergängen in einem Halbleiterkristall aufgebaut. Dabei werden entweder zwei n-dotierte Gebiete durch ein p-dotiertes Gebiet voneinander getrennt (sogenannte npn-Transistoren) oder zwei p-dotierte Gebiete durch ein n-dotiertes Gebiet (pnp-Transistoren). Die drei unterschiedlich dotierten Gebiete werden als Emitter (E), Basis (B) und Kollektor (C) bezeichnet. Bipolartransistoren sind bereits seit langem bekannt und werden auf vielfältige Art und Weise eingesetzt. Bei Bipolartransistoren unterscheidet man zwischen sogenannten Einzeltransistoren, die für die Montage auf Leiterplatten gedacht und in einem eigenen Gehäuse untergebracht sind, und sogenannten integrierten Transistoren, die zusammen mit weiteren Halbleiterbauelementen auf einem gemeinsamen Halbleiterträger, der in der Regel als Substrat bezeichnet wird, hergestellt werden.

Neben der Transitfrequenz des Bipolartransistors, bei der es sich um eine seiner Grenzfrequenzen handelt, sind der Basiswiderstand und die Basis-Kollektor-Kapazität entscheidende Transistorparameter, die wichtige Kenngrößen wie die maximale Oszillationsfrequenz, die Leistungsverstärkung, die minimale Rauschzahl, die Gatterverzögerungszeiten und dergleichen bestimmen.

So gilt zum Beispiel näherungsweise:

$$f_{max} = \sqrt{\frac{f_T}{8\pi \times R_B \times C_{BC}}}$$

wobei mit $f_{max}$ die maximale Oszillationsfrequenz, $f_T$ die Transitfrequenz, $R_B$ der Basiswiderstand und $C_{BC}$ die Basis-Kollektor-Kapazität bezeichnet ist.

Die Transitfrequenz wird im wesentlichen durch das Dotierstoffprofil im aktiven Transistorgebiet bestimmt. Das Produkt $R_B{}^*C_{BC}$ läßt sich dagegen durch das Transistorlayout, das heißt den geometrischen Aufbau, beeinflussen.

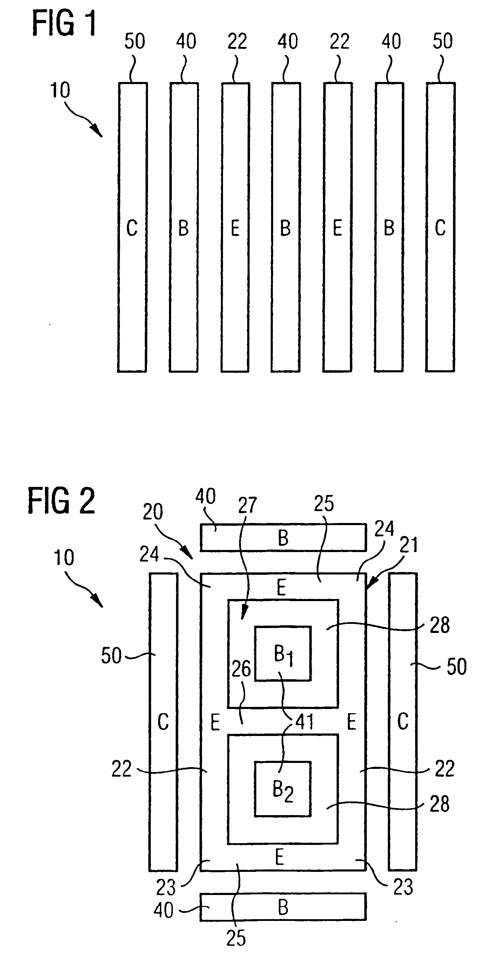

Bei bisher bekannten Bipolartransistoren, beispielsweise sogenannten Silizium-Mikrowellen-Transistoren, wird im allgemeinen ein Transistorlayout verwendet, wie es schematisch in Figur 1 dargestellt ist. Solche Bipolartransistoren weisen wenigstens einen aus einem oder mehreren Emitterelementen gebildeten Emitter, einen oder mehrere Basiskontakt(e) und einen oder mehrere Kollektorkontakt(e) auf. Dabei sind der wenigstens eine Emitter, der wenigstens eine Basiskontakt sowie der wenigstens eine Kollektorkontakt zur Bildung des Transistorlayouts in einer bestimmten Anordnung zueinander vorgesehen.

Wie in Figur 1 dargestellt ist, kann der Emitter (E) streifenförmig ausgeführt sein, wobei die Emitterstreifenbreite durch die minimal mögliche Lithographiebreite gegeben ist. Dies führt zu einem möglichst geringen internen Basisbahnwiderstand. Um den gesamten Basiswiderstand zu minimieren, wird jeder Emitterstreifen von zwei Basisanschlußstreifen (B) umgeben. Meist verwendet man zwei Emitterstreifen, so daß nur drei (statt vier) Basisstreifen benötigt werden, weil der mittlere Basiskontakt für beide Emitterstreifen verwendet werden kann.
Die Kollektorkontakte (C) werden neben den äußeren Basiskontakten ausgeführt.

Das beschriebene Transistorlayout kann für eine gegebene minimale Lithographiebreite den minimal möglichen Basiswiderstand liefern.

Durch eine Verlängerung der Emitterstreifen ließe sich der Basiswiderstand verkleinern, da der Basiswiderstand $R_B$ proportional ist zu $1/l_E$, mit $l_E$ gleich der Emitterlänge. Allerdings ist jedoch die Basis-Kollektor-Kapazität $C_{BC}$ proportional zur Emitterlänge $l_E$, so daß das Produkt $R_B{}^*C_{BC}$ in erster Näherung unabhängig von der Emitterlänge $l_E$ ist.

Die gesamte Emitterfläche wird bei den bekannten Bipolartransistoren derart gewählt, daß sich der in der Anwendung der Bipolartransistoren jeweils gewünschte Strom ergibt.

Derartige bekannte Bipolartransistoren können beispielsweise für die sogenannte selbstjustierte Doppel-Polysilizium-Technologie eingesetzt werden.

Ausgehend vom bekannten Stand der Technik liegt der vorliegenden Erfindung die Aufgabe zu Grunde, einen Bipolartransistor bereitzustellen, der bezüglich seiner Transistorparameter ein im Hinblick auf die bekannten Lösungen optimiertes Transistorlayout hat.

Die U.S.-Patente, 5,455,186 4,680,608 und 5,675,175 zeigen Beispiele von aus dem Stand der Technik Benannten Transistoren.

Diese Aufgabe wird erfindungsgemäß gelöst durch einen Bipolar-transistor wie in Anspruch 1 Beansprucht.

Auf diese Weise kann ein optimierter Transistoraufbau erzielt werden, der bei gleichen Design-Regeln (das heißt gleichen Anforderungen an die Technologiegeneration) ein wesentlich geringeres Produkt $R_B{}^*C_{BC}$ als bei den bisher üblicherweise verwendeten Transistorlayouts, wie sie beispielsweise in Figur 1 dargestellt und weiter oben beschrieben sind, ermöglicht. Dadurch werden die Eigenschaften des Bipolartransistors verbessert. Insbesondere können durch den erfindungsgemäßen Bipolartransistor deutlich verbesserte HF-Eigenschaften (Hochfrequenzeigenschaften) dieser Transistoren ermöglicht werden, wie zum Beispiel höhere Transit- sowie maximale Oszillationsfrequenzen und geringere Rauschzahl.

Ein wesentlicher Unterschied des erfindungsgemäßen Bipolartransistors im Vergleich zu den im Stand der Technik bekannten Bipolartransistoren besteht darin, daß nicht eine Lösung für den minimalen Basiswiderstand $R_B$ gewählt wird, sondern daß gezielt das Produkt $R_B * C_{Bc}$ optimiert wird. Dies kann, wie im weiteren Verlauf der Beschreibung noch eingehender erläutert wird, zwar zu geringfügig höheren Werten für $R_B$ führen, allerdings werden deutlich geringere Werte für die Basis-Kollektor-Kapazität $C_{Bc}$ erreicht.

Im Unterschied zum bisher bekannten Transistorlayout wird der Emitter nunmehr derart ausgeführt, daß er wenigstens eine geschlossene Emitterkonfiguration aufweist. Das bedeutet, daß der Emitter wenigstens ein durchgängiges Bauelement aufweist, wobei dieses durchgängige Bauelement wenigstens einen Emitter-Innenraum begrenzt beziehungsweise umgibt. Innerhalb dieses Emitter-Innenraums kann sich wenigstens ein Basiskontakt befinden.

Die Erfindung ist nicht auf bestimmte Ausgestaltungsformen für die erfindungsgemäße Emitterkonfiguration beschränkt. Einige nicht ausschließliche, exemplarische Ausführungsformen werden im Zusammenhang mit der Figurenbeschreibung näher erläutert.

Bevorzugte Ausführungsformen des erfindungsgemäßen Bipolartransistors ergeben sich aus den Unteransprüchen.

Vorteilhaft kann die Emitterkonfiguration zwei oder mehr Emitterelemente aufweisen, die zur Bildung der geschlossenen Emitterkonfiguration miteinander verbunden sind.

Dazu kann die Emitterkonfiguration beispielsweise zwei oder mehr streifenförmige Emitterelemente aufweisen, die parallel und beabstandet zueinander ausgerichtet sind. Weiterhin können die streifenförmigen Emitterelemente an ihren freien Enden jeweils über ein als äußerer Emittersteg ausgebildetes Emitterelement miteinander verbunden sein. Wenn mehr als zwei streifenförmige Emitterelemente für die Emitterkonfiguration eingesetzt werden, kann der äußere Emittersteg aus einer entsprechenden Anzahl von Einzelbestandteilen bestehen, die dann in ihrer Gesamtheit den äußeren Emittersteg bilden. Im Unterschied zum bekannten Transistorlayout wird der Emitter nunmehr nicht mehr nur streifenförmig ausgeführt, sondern die beiden Emitterstreifen werden durch Zwischenstege verbunden.

In weiterer Ausgestaltung kann zwischen den beiden äußeren Emitterstegen wenigstens ein weiterer, die beiden streifenförmigen Emitterelemente verbindender innerer Emittersteg vorgesehen sein, über den der Emitter-Innenraum in zwei oder mehr Teilräume unterteilt wird. In einer solchen Ausgestaltung hat die Emitterkonfiguration bei Verwendung nur eines einzigen inneren Emitterstegs in Aufsicht damit schematisch die Form einer "Acht". Die Erfindung ist nicht auf eine bestimmte Anzahl von inneren Emitterstegen begrenzt. Bei Verwendung mehrerer streifenförmiger Emitterelemente kann der/die innere Emittersteg(e) wiederum aus einer entsprechenden Anzahl von Emittersteg-Bestandteilen gebildet sein.

Zwischen die einzelnen Emitterstege können jeweils Basiskontakte gesetzt werden. Das bedeutet, daß diese Basiskontakte vorteilhaft in einem oder mehreren der Teilräume angeordnet sein können.

Die Länge der äußeren und optional der inneren Emitterstege - und damit der Abstand zwischen den streifenförmigen Emitterelementen- wird vorzugsweise so klein gewählt, wie es die Design-Regeln für die minimal mögliche Größe der Basiskontakte erlauben.

Vorzugsweise kann der Emitter zwei oder mehr geschlossene Emitterkonfigurationen aufweisen.

Vorteilhaft können außerhalb der Emitterkonfiguration wenigstens zwei streifenförmige Basiskontakte und/oder zwei streifenförmige Kollektorkontakte vorgesehen sein.

Die streifenförmigen Basiskontakte können parallel und beabstandet zu den äußeren Emitterstegen ausgerichtet sein.

Die streifenförmigen Kollektorkontakte hingegen können parallel und beabstandet zu den streifenförmigen Emitterelementen ausgerichtet sein.

Die Vorteile einer solchen Ausrichtung der Basiskontakte und/oder Kollektorkontakte werden im weiteren Verlauf der Beschreibung näher erläutert.

Vorzugsweise kann der wenigstens eine Emitter in einer ersten Metallisierungsebene angeschlossen oder anschließbar sein.

In weiterer Ausgestaltung kann der wenigstens eine Basiskontakt in eine parallel und räumlich beabstandet zur ersten Metallisierungsebene liegende zweite Metallisierungsebene geführt oder führbar sein.

Dies soll an Hand eines Beispiels verdeutlicht werden. Wenn der Emitter beispielsweise in der ersten Metallisierungsebene angeschlossen wird, können die Basiskontakte in die zweite Metallisierungsebene nach oben geführt und in dieser dann über die Emitterstege zu den jeweiligen Kontaktgebieten oben und unten geführt werden. Die Verwendung von zwei solcher Verdrahtungsebenen stellt im Vergleich zu den bekannten Bipolartransistortypen keinen zusätzlichen Aufwand dar, weil auch bei diesen zwei Metallisierungsebenen benötigt werden, um den Emitter, die Basis und den Kollektor zu kontaktieren und um einen Anschluß an die sogenannten Bondpads herzustellen.

Der Basisanschluß zwischen dem wenigstens einen Emitter und dem wenigstens einen Kollektorkontakt erfolgt über ein Basis-Polysilizium-Material. Ein solcher Basisanschluß hat bei dem Bipolartransistor die Funktion der Steuerelektrode. Mit dem Basisanschluß kann der Strom vom Emitter zum Kollektor, der als Transferstrom bezeichnet werden, gesteuert werden. Bei der erfindungsgemäßen Ausgestaltung des Bipolartransistors liegt zwischen dem Emitter und dem wenigstens einen Kollektorkontakt kein eigener Basiskontakt mehr vor, wie dies bei den aus dem Stand der Technik bekannten Bipolartransistortypen der Fall war. Auf der Seite zwischen dem Emitter und dem Kollektorkontakt erfolgt der Basisanschluß deshalb nunmehr über das Basis-Polysilizium-Material.

Besonders vorteilhaft kann dieses Material als Silizid ausgeführt sein. Damit kann der Bipolartransistor besonders effizient ausgeführt werden. Bei Verwendung von Silizid ist der Schichtwiderstand im Vergleich zu Polysilizium so niedrig, daß zwischen Emitter und Kollektorkontakt auch ohne nahen Metallkontakt ein niederohmiger Basisanschluß realisiert werden kann.

Der erfindungsgemäße Bipolartransistor führt im Vergleich zum bisher bekannten Transistordesign (siehe Figur 1) bei gleich großer Emitterfläche, das heißt bei gleicher Stromergiebigkeit, zu einer wesentlich kompakteren Anordnung und damit zu einer wesentlich kleineren Basis-Kollektor-Kapazität $C_{Bc}$. Außerdem wird der Kollektorwiderstand $R_C$ deut-lich reduziert, weil Emitter und Kollektorkontakt nicht mehr durch einen Basiskontakt voneinander getrennt sind. Bei gleichen Designregeln kann durch die Layoutoptimierung die Transistorfläche um etwa 40% reduziert werden.

Um den Einfluß der durchgeführten Layoutmaßnahme bei dem erfindungsgemäßen Bipolartransistor auf den Basiswiderstand $R_B$ und die Basis-Kollektor-Kapazität $C_{Bc}$ abzuschätzen, wurden verschiedene Simulationstests durchgeführt. Die Ergebnisse dieser Simulationen sind in der nachfolgenden Tabelle 1 dargestellt:

Tabelle 1

| Typ | $R_B$ [Ω] | $C_{BC}$ [fF] | $R_B*C_{BC}$ [fs] |
|---|---|---|---|
| Standard | 22,1 | 37,3 | 824 |
| Standard siliziert | 20,8 | 37,3 | 776 |
| Neues Layout | 25,2 | 23,8 | 600 |
| Neues Layout siliziert | 21,2 | 23,8 | 505 |

Die Tabelle 1 zeigt berechnete Werte für den Basiswiderstand $R_B$, die Basis-Kollektor-Kapazität $C_{BC}$ sowie das Produkt $R_B*C_{BC}$. Die Werte wurden berechnet für ein wie aus dem Stand der Technik bekanntes sowie ein erfindungsgemäß optimiertes Transistordesign für einen Transistor mit 10 $\mu m^2$ Emittermaskenfläche. Gezeigt sind in Tabelle 1 die Ergebnisse für eine im Stand der Technik bekannte Konfiguration, die mit "Standard" bezeichnet ist, eine aus dem Stand der Technik bekannte Konfiguration mit siliziertem Basis-Polysilizium, die "Standard siliziert" bezeichnet wird, eine optimierte Konfiguration gemäß der vorliegenden Erfindung, die als "neues Layout" bezeichnet ist und eine erfindungsgemäße Konfiguration mit siliziertem Basis-Polysilizium, die als "neues Layout siliziert" bezeichnet ist.

Ohne Silizid führt die Verwendung des erfindungsgemäßen Bipolartransistor-Layouts im Vergleich zum aus dem Stand der Technik bekannten Transistorlayout zu einer Verringerung des Produktwertes $R_B*C_{Bc}$ um 27%. Wird jeweils Silizid verwendet, ist der Vorteil bei einer Verringerung um 35% noch größer.

Zusammenfassend können durch das erfindungsgemäße Bipolartransistor-Layout unter anderem die nachfolgenden Vorteile erreicht werden. Zunächst kann das Produkt $R_B*C_{BC}$ deutlich verkleinert werden. Weiterhin kann auch eine Verkleinerung des Kollektorwiderstandes $R_C$ realisiert werden. Mit dem erfindungsgemäßen Bipolartransistor sind darüber hinaus höhere Transitfrequenzen, höhere maximale Oszillationsfrequenzen sowie kleinere Rauschzahlen möglich. Weiterhin kann die Kollektor-Substrat-Kapazität und damit auch der Leistungsverbrauch verkleinert werden. Zusätzlich benötigen die erfindungsgemäßen Bipolartransistoren einen geringeren Platzbedarf, so daß mehr Transistoren pro Fläche hergestellt werden können, was zu geringeren Herstellungskosten führt. Die erzielbaren Vorteile sind durch eine reine Layoutmaßnahme realisierbar, so daß sie völlig kostenneutral sind. Zusätzliche Prozeßmodule sind nicht notwendig. Schließlich sind die erfindungsgemäßen Bipolartransistoren sehr universell, das heißt für alle Bipolartechnologien einsetzbar, so daß sich ihnen ein großes Marktvolumen eröffnet.

Besonders vorteilhaft kann ein wie vorstehend beschriebener erfindungsgemäßer Bipolartransistor als Mikrowellen-Transistor verwendet werden. Jedoch ist die Erfindung nicht auf diese Bipolartransistortypen beschränkt, so daß sie auch auf alle anderen Bipolartransistoren in integrierten Schaltungen anwendbar ist.

Die Erfindung wird nun an Hand von Ausführungsbeispielen unter Bezugnahme auf die beiliegende Zeichnung näher erläutert. Es zeigen:

Figur 1          ein schematisches Layout eines aus dem Stand der Technik bekannten Bipolartransistors;

Figur 2          ein schematisches Layout einer ersten Ausführungsform eines optimierten Transistoranordnung gemäß der vorliegenden Erfindung;

Figur 3            ein schematisches Layout einer weiteren Ausführungsform eines optimierten Transistoranordnung gemäß der vorliegenden Erfindung;

Figur 4            ein schematisches Layout einer anderen Ausführungsform eines optimierten Transistoranordnung gemäß der vorliegenden Erfindung;

Figur 5            ein schematisches Layout noch einer anderen Ausführungsform eines optimierten Transistoranordnung gemäß der vorliegenden Erfindung; und

Figuren 6a und 6b  einen maßstabsgetreuen Größenvergleich für einen aus dem Stand der Technik bekannten Transistor gemäß Figur 1 (Figur 6a) und einen Transistor mit optimiertem Layout gemäß der vorliegenden Erfindung nach Figur 2 (Figur 6b), bei gleicher Emitterfläche, das heißt bei gleicher Stromergiebigkeit.

In Figur 1 ist ein Bipolartransistor 10 in Form eines diskreten Silizium-Mikrowellentransistors dargestellt. Der Bipolartransistor 10 weist ein aus dem Stand der Technik bekanntes Layout auf.

Der Bipolartransistor 10 weist einen aus zwei streifenförmigen Emitterelementen 22 gebildeten Emitter (E) auf. Die Breite der jeweiligen Emitterstreifen 22 ist durch die minimal mögliche Lithographiebreite gegeben. Um den gesamten Basiswiderstand $R_B$ des Bipolartransistors 10 zu minimieren, wird jedes streifenförmige Emitterelement 22 von zwei streifenförmigen Basiskontakten (B) 40 flankiert. Im Ausführungsbeispiel gemäß Figur 1 werden zwei streifenförmige Emitterelemente 22 verwendet, so daß nur drei, anstelle von vier, streifenförmigen Basiskontakten 40 erforderlich sind, weil der mittlere Basiskontakt für beide Emitterelemente 22 verwendet werden kann. Neben den äußeren Basiskontakten 40 werden jeweils zwei streifenförmige Kollektorkontakte (C) 50 ausgeführt.

Um dieses Bipolartransistor-Layout in einer Weise zu optimieren, wie dies im Rahmen der Beschreibung weiter oben eingehend dargelegt wurde, wird erfindungsgemäß ein Layout für den Bipolartransistor 10 vorgeschlagen, wie es schematisch in Figur 2 dargestellt ist.

Der Bipolartransistor 10 weist einen Emitter (E) 20 auf, der aus zwei streifenförmigen Emitterelementen 22 gebildet ist. Die beiden streifenförmigen Emitterelemente 22 sind parallel und beabstandet zueinander ausgerichtet. An ihren freien Enden 23, 24 sind die streifenförmigen Emitterelemente 22 jeweils über einen äußeren Emittersteg 25 miteinander verbunden. Dadurch entsteht ein Emitter 20 mit einer geschlossenen Emitterkonfiguration 21, wobei die Emitterkonfiguration 21 einen Emitter-Innenraum 27 begrenzt beziehungsweise umgibt.

Zwischen den beiden äußeren Emitterstegen 25 ist ein weiterer, die beiden streifenförmigen Emitterelemente 22 verbindender innerer Emittersteg 26 vorgesehen. Über diesen zusätzlichen inneren Emittersteg 26 wird der Emitter-Innenraum 27 in zwei Teilräume 28 unterteilt. Der Emitter 20 hat in Aufsicht damit schematisch die Form einer "Acht".

Zwischen die Emitterstege 25, 26, das heißt in die Teilräume 28, werden Basiskontakte (B1, B2) 41 gesetzt. Der Abstand der beiden streifenförmigen Emitterelemente 22, das heißt die Länge der äußeren und inneren Emitterstege 25, 26 wird derart klein gewählt, wie es die Designregeln für die minimal mögliche Größe der in den Teilräumen 28 befindlichen Basiskontakte 41 zuläßt.

Parallel und beabstandet zu den äußeren Emitterstegen 25 sind außerhalb der geschlossenen Emitterkonfiguration 21 zwei streifenförmige Basiskontakte (B) 40 vorgesehen. Weiterhin sind parallel und beabstandet zu den streifenförmigen Emitterelementen 22 außerhalb der geschlossenen Emitterkonfiguration 21 zwei streifenförmige Kollektorkontakte (C) 50 vorgesehen.

Der Emitter 20 wird in einer ersten Metallisierungsebene angeschlossen. Die Basiskontakte 40, 41 werden in einer zweiten Metallisierungsebene nach oben geführt und können in dieser dann über die Emitterstege 25, 26 zu den jeweiligen Kontaktgebieten oben und unten geführt werden.

Wie sich aus dem Vergleich zwischen Figur 1 und Figur 2 ergibt, liegt bei dem in Figur 2 dargestellten erfindungsgemäßen Bipolartransistor-Layout zwischen dem Emitter 20 und den Kollektorkontakten 50 nunmehr kein eigener Basiskontakt mehr vor. Der Basisanschluß erfolgt an dieser Stelle daher über Basis-Polysilizium-Material, das besonders bevorzugt als Silizid ausgeführt wird.

Das in Figur 2 dargestellte Ausführungsbeispiel des erfindungsgemäßen Bipolartransistors führt im Vergleich zu dem in Figur 1 dargestellten Layout bei gleich großer Emitterfläche, das heißt bei gleicher Stromergiebigkeit, zu einer wesentlich kompakteren Anordnung und damit zu einer kleineren Basis-Kollektor-Kapazität. Außerdem wird der Kollektorwiderstand deutlich reduziert, weil Emitter 20 und Kollektorkontakt 50 nicht mehr durch einen Basiskontakt voneinander getrennt sind.

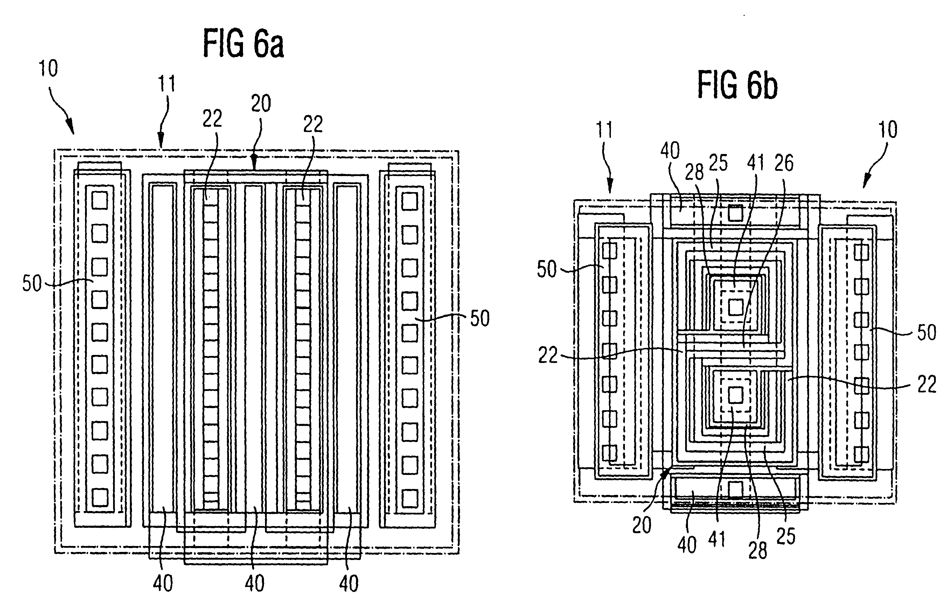

Der Umfang der möglichen Platzersparnis durch das erfindungsgemäße Bipolartransistor-Layout ist aus den Figuren 6a und 6b ersichtlich. Diese beiden Figuren zeigen einen maßstabsgetreuen Vergleich für das Layout eines aus dem Stand der Technik bekannten Bipolartransistors 10, wie er in Figur 1 dargestellt ist. Dieses Layout ist in Figur 6a gezeigt. Figur 6b zeigt das Layout eines erfindungsgemäßen Bipolartransistors 10, wie er in Figur 2 dargestellt und beschrieben ist.

Wie sich aus dem direkten Vergleich zwischen den Figuren 6a und 6b ergibt, kann bei gleichen Designregeln durch eine Layoutoptimierung für jeweils gleich große Emitterflächen die Transistorfläche um etwa 40% reduziert werden.

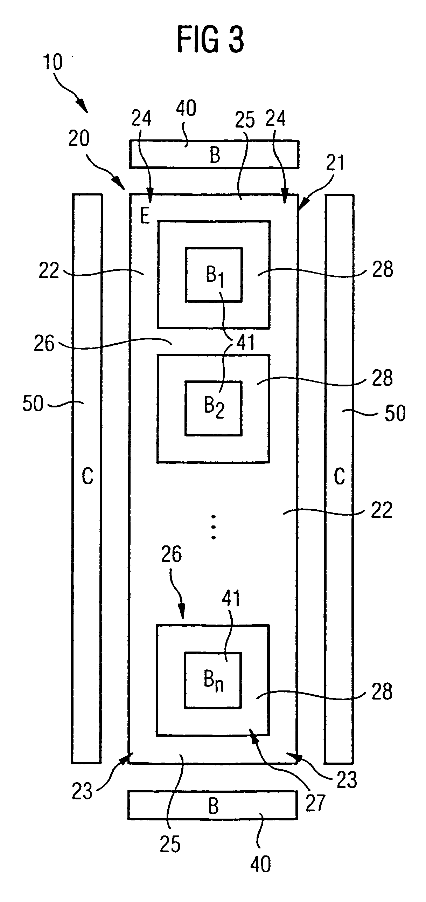

In Figur 3 ist eine andere Ausführungsform eines Bipolartransistors 10 mit einem optimierten Transistorlayout dargestellt. Der in Figur 3 dargestellte Emitter 20 entspricht in seinem Grundaufbau sowie im Hinblick auf die Flankierung durch jeweils zwei streifenförmige Basiskontakte 40 und Kollektorkontakte 50 dem Aufbau des in Figur 2 dargestellten Bipolartransistors, so daß zur Vermeidung von Wiederholungen auf diese Beschreibung verwiesen wird.

Im Unterschied zu der in Figur 2 dargestellten Ausführungsform weist der Bipolartransistor 10 gemäß Figur 3 mehr als zwei innere Emitterstege 26 auf, so daß auch mehr als zwei Teilräume 28 des Emitter-Innenraums 27 gebildet werden. Die Anzahl der auf diese Weise gebildeten Teilräume ist beliebig und kann je nach Bedarf und Anwendungsfall entsprechend gewählt werden. In jedem der Teilräume 28 ist ein Basiskontakt 41 vorgesehen. Um die freie Variierbarkeit der Anzahl an Teilräumen 28 und der darin befindlichen Basiskontakte 41 zu unterstreichen, ist in Figur 3 eine nicht abgeschlossene Reihe von Basiskontakten (B1, B2,...Bn) 41 dargestellt.

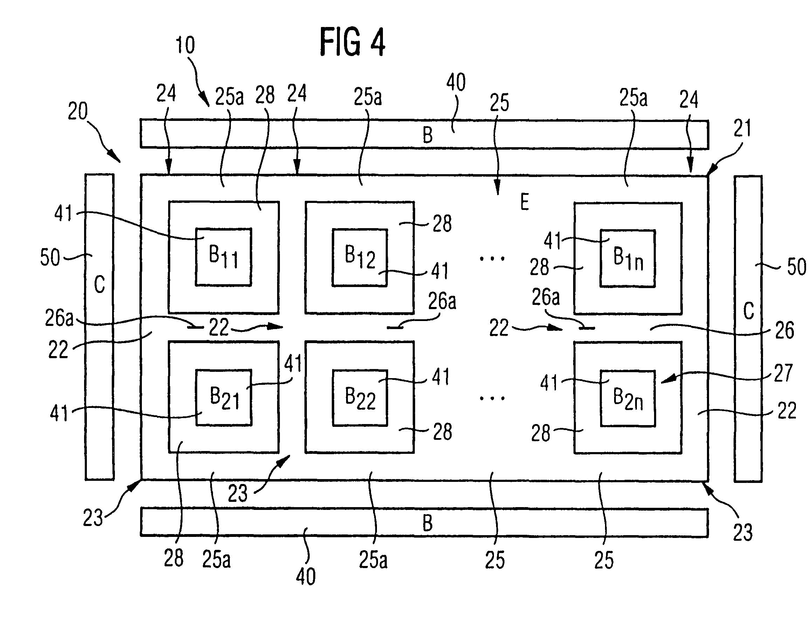

In Figur 4 ist eine andere Ausgestaltungsform des erfindungsgemäßen Bipolartransistors 10 dargestellt. Der Bipolartransistor 10 weist einen Emitter (E) 20 auf, der wiederum eine geschlossene Emitterkonfiguration 21 aufweist. Im Unterschied zu den zuvor beschriebenen Ausführungsbeispielen sind jedoch mehr als zwei streifenförmige Emitterelemente 22 vorgesehen, die parallel und beabstandet zueinander ausgerichtet sind. Um eine geschlossene Emitterkonfiguration 21 zu erzeugen, sind die einzelnen Emitterstreifen 21 an ihren jeweiligen freien Enden 23, 24 über Bestandteile 25a eines äußeren Emitterstegs miteinander verbunden. Die einzelnen Bestandteile 25a bilden in ihrer Gesamtheit den äußeren Emittersteg 25.

Ebenso sind zwischen den einzelnen Bestandteilen 25a des äußeren Emitterstegs 25 einzelne Bestandteile 26a eines inneren Emitterstegs 26 vorgesehen. Im Beispiel gemäß Figur 4 wird auf diese Weise nur ein einziger innerer Emittersteg 26 gebildet, so daß die geschlossene Emitterkonfiguration 21 zwei Reihen und eine beliebige Anzahl Spalten von Teilräumen 28 im Emitter-Innenraum 27 umgrenzt. Bei Einsatz einer wie in Figur 3 dargestellten Grundkonfiguration kann die Anzahl der Reihen ebenfalls beliebig vergrößert werden.

Das in Figur 4 dargestellte Ausführungsbeispiel verfügt über eine beliebige Anzahl von Spalten an Teilräumen 28, in denen eine beliebige Anzahl von Basiskontakten (B11, B12;...B1n; B21, B22,...B2n) vorgesehen ist.

Die äußeren Emitterstege 25 werden jeweils von zwei streifenförmigen Basiskontakten (B) 40 flankiert. Benachbart zu den jeweils außen liegenden streifenförmigen Emitterelementen 22 sind zwei streifenförmige Kollektorkontakte (C) 50 vorgesehen.

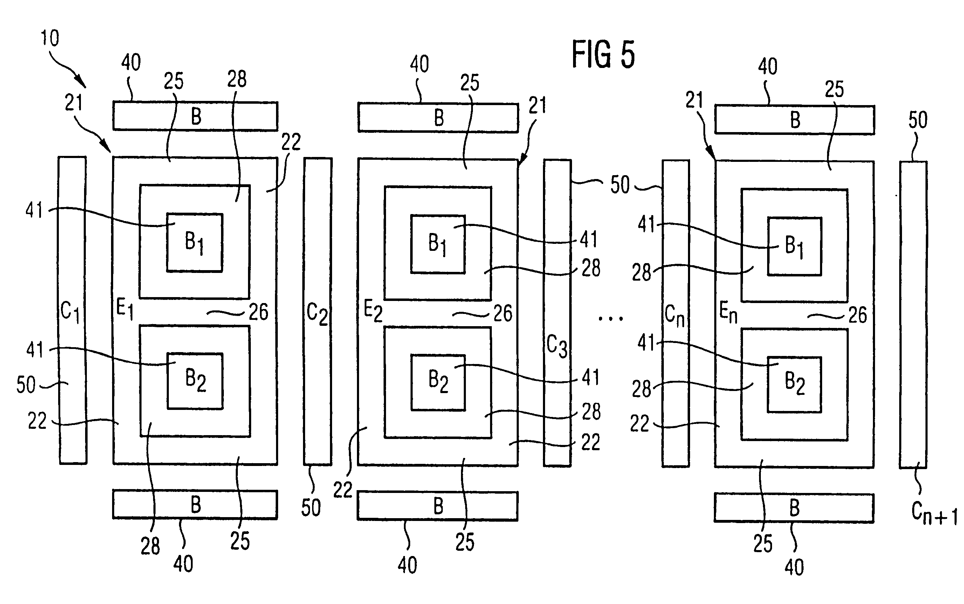

In Figur 5 ist ein weiterer Bipolartransistor 10 dargestellt, der einen Emitter (E) 20 mit einer beliebigen Anzahl von benachbart zueinander angeordneten geschlossenen Emitterkonfigurationen (E1, E2,...En) 21 aufweist. Jede Emitterkonfiguration 21 weist einen wie in Figur 2 dargestellten Aufbau auf, könnte jedoch auch jeden anderen Aufbau haben. Jede Emitterkonfiguration 21 wird außerhalb ihrer äußeren Emitterstege 25 von jeweils einem streifenförmigen Basiskontakt (B) 40 flankiert. Die einzelnen streifenförmigen Emitterelemente 22 jeder Emitterkonfiguration 21 werden von streifenförmigen Kollektorkontakten (C) 50 flankiert. Jeweils benachbarte Emitterkonfigurationen 21 können sich einen einzigen, dazwischenliegenden Kollektorkontakt 50 teilen. Auf diese Weise weist ein Emitter 20 mit n geschlossenen Emitterkonfigurationen (E1, E2,...En) 21 insgesamt n+1 Kollektorkontakte (C1, C2,...Cn, Cn+1) 50 auf.

**Patentansprüche**

1. Bipolartransistor, mit wenigstens einem aus einem oder mehreren Emitterelementen gebildeten Emitter, mit zwei oder mehreren Basiskontakten und mit einem oder mehreren Kollektorkontakten, wobei der wenigstens eine Emitter, die wenigsten zwei Basiskontakte sowie der wenigstens eine Kollektorkontakt zur Bildung des Transistorlayouts in einer bestimmten Anordnung zueinander vorgesehen: sind, wobei der Emitter (20) wenigstens eine geschlossene Emitterkonfiguration (21) aufweist, die wenigstens eine Emitterkonfiguration (21) wenigstens einen Emitter-Innenraum (27) begrenzt, zwei oder mehr Basiskontakte (40, 41) vorgesehen sind, wenigstens einer der Basiskontakte (41) im Emitter-Innenraum (27) angeordnet ist und der wenigstens eine andere Basiskontakt (40) sowie der wenigstens eine Kollektorkontakt (50) außerhalb der Emitterkonfiguration (21) angeordnet sind, **dadurch gekennzeichnet, daß** zwischen Emitter (20) und dem Kollektorkontakt (50) kein eigener Basiskontakt vorliegt und der Basisanschluß zwischen Emitter (20) und dem Kollektorkontakt (50) über Basis-Polysilizium-Material erfolgt.

2. Bipolartransistor nach Anspruch 1, **dadurch gekennzeichnet, daß** die Emitterkonfiguration (21) zwei oder mehr Emitterelemente (22, 25, 26) aufweist, die miteinander verbunden sind.

**3.** Bipolartransistor nach Anspruch 1 oder 2, **dadurch gekennzeichnet, daß** die Emitterkonfiguration (21) zwei oder mehr streifenförmige Emitterelemente (22) aufweist, die parallel und beabstandet zueinander ausgerichtet sind und daß die streifenförmigen Emitterelemente (22) an ihren freien Enden (23, 24) jeweils über ein als äußerer Emittersteg (25) ausgebildetes Emitterelement miteinander verbunden sind.

**4.** Bipolartransistor nach Anspruch 3, **dadurch gekennzeichnet, daß** zwischen den beiden äußeren Emitterstegen (25) wenigstens ein weiterer, die beiden streifenförmigen Emitterelemente (22) verbindender innerer Emittersteg (26) vorgesehen ist, über den der Emitter-Innenraum (27) in zwei oder mehr Teilräume (28) unterteilt wird.

**5.** Bipolartransistor nach Anspruch 4, **dadurch gekennzeichnet, daß** in einem oder mehreren der Teilräume (28) ein Basiskontakt (41) angeordnet ist.

**6.** Bipolartransistor nach einem der Ansprüche 1 bis 5, **dadurch gekennzeichnet, daß** der Emitter (20) zwei oder mehr geschlossene Emitterkonfigurationen (21) aufweist.

**7.** Bipolartransistor nach einem der Ansprüche 1 bis 6, **dadurch gekennzeichnet, daß** außerhalb der wenigstens einen Emitterkonfiguration (21) wenigstens zwei streifenförmige Basiskontakte (40) und/oder wenigstens zwei streifenförmige Kollektorkontakte (50) vorgesehen sind.

**8.** Bipolartransistor nach Anspruch 7, soweit dieser auf einen der Ansprüche 3 bis 6 rückbezogen ist, **dadurch gekennzeichnet, daß** die streifenförmigen Basiskontakte (40) parallel und beabstandet zu den äußeren Emitterstegen (25) ausgerichtet sind.

**9.** Bipolartransistor nach Anspruch 7, soweit dieser auf einen der Ansprüche 3 bis 6 rückbezogen ist, **dadurch gekennzeichnet, daß** die streifenförmigen Kollektorkontakte (50) parallel und beabstandet zu den streifenförmigen Emitterelementen (22) ausgerichtet sind.

**10.** Bipolartransistor nach einem der Ansprüche 1 bis 9, **dadurch gekennzeichnet, daß** der wenigstens eine Emitter (20) in einer ersten Metallisierungsebene angeschlossen oder anschließbar ist.

**11.** Bipolartransistor nach Anspruch 10, **dadurch gekennzeichnet, daß** der wenigstens eine Basiskontakt (40, 41) in eine parallel und räumlich beabstandet zur ersten Metallisierungsebene liegende zweite Metallisierungsebene geführt oder führbar ist.

**12.** Bipolartransistor nach einem der Ansprüche 1 bis 11, **dadurch gekennzeichnet, daß** das Basis-Polysilizium als Silizid ausgeführt ist.

**13.** Verwendung eines Bipolartransistors (10) nach einem der Ansprüche 1 bis 12 als Mikrowellen-Transistor.

**Claims**

**1.** Bipolar transistor, having at least one emitter formed from one or more emitter elements, having two or more base contacts and having one or more collector contacts, the at least one emitter, the at least two base contacts and the at least one collector contact being provided in a specific arrangement with respect to one another for the formation of the transistor layout, the emitter (20) having at least one closed emitter configuration (21), the at least one emitter configuration (21) bounding at least one emitter inner space (27), two or more base contacts (40, 41) being provided, at least one of the base contacts (41) being arranged in the emitter inner space (27) and the at least one other base contact (40) and also the at least one collector contact (50) being arranged outside the emitter configuration (21), **characterized in that** no dedicated base contact is present between emitter (20) and the collector contact (50) and the base connection is effected between emitter (20) and the collector contact (50) via base polysilicon material.

**2.** Bipolar transistor according to claim 1, **characterized in that** the emitter configuration (21) has two or more emitter elements (22, 25, 26) which are connected to one another.

**3.** Bipolar transistor according to Claim 1 or 2, **characterized in that** the emitter configuration (21) has two or more strip-type emitter elements (22) which are oriented parallel and spaced apart with respect to one another, and **characterized in that** the strip-type emitter elements (22) are connected to one another at their free ends (23, 24) in each case via an emitter element formed as an outer emitter web (25).

4. Bipolar transistor according to Claim 3, **characterized in that** at least one further, inner emitter web (26) which connects the two strip-type emitter elements (22) is provided between the two outer emitter webs (25), via which inner emitter web the emitter inner space (27) is subdivided into two or more partial spaces (28).

5. Bipolar transistor according to Claim 4, **characterized in that** a base contact (41) is arranged in one or more of the partial spaces (28).

6. Bipolar transistor according to one of Claims 1 to 5, **characterized in that** the emitter (20) has two or more closed emitter configurations (21).

7. Bipolar transistor according to one of Claims 1 to 6, **characterized in that** at least two strip-type base contacts (40) and/or at least two strip-type collector contacts (50) are provided outside the at least one emitter configuration (21).

8. Bipolar transistor according to Claim 7, insofar as it is referred back to one of Claims 3 to 6, **characterized in that** the strip-type base contacts (40) are oriented parallel and spaced apart with respect to the outer emitter webs (25).

9. Bipolar transistor according to Claim 7, insofar as it is referred back to one of Claims 3 to 6, **characterized in that** the strip-type collector contacts (50) are oriented parallel and spaced apart with respect to the strip-type emitter elements (22).

10. Bipolar transistor according to one of Claims 1 to 9, **characterized in that** the at least one emitter (20) is connected or can be connected in a first metalization plane.

11. Bipolar transistor according to Claim 10, **characterized in that** the at least one base contact (40, 41) is led or can be led into a second metalization plane lying parallel and spatially spaced apart relative to the first metalization plane.

12. Bipolar transistor according to one of Claims 1 to 11, **characterized in that** the base polysilicon is embodied as silicide.

13. Use of a bipolar transistor (10) according to one of Claims 1 to 12 as a microwave transistor.

## Revendications

1. Transistor bipolaire comprenant au moins un émetteur formé d'un élément d'émetteur ou de plusieurs éléments d'émetteur, deux ou plusieurs contacts de base et un ou plusieurs contacts de collecteur, le au moins un émetteur, les au moins deux contacts de base ainsi que le au moins un contact de collecteur étant prévus dans un agencement déterminé les uns par rapport aux autres pour la formation de l'implantation du transistor, l'émetteur du transistor ayant au moins une configuration (21) d'émetteur qui est fermée, la au moins une configuration (21) d'émetteur délimitant au moins un espace (27) intérieur d'émetteur, deux ou plusieurs contacts (40,41) de base étant prévus, au moins l'un des contacts (41) de base étant disposé dans l'espace (27) intérieur d'émetteur et le au moins un autre contact (40) de base ainsi que le au moins un contact (50) de collecteur étant disposé à l'extérieur de la configuration (21) d'émetteur, **caractérisé en ce qu'**entre l'émetteur (20) et le contact (50) de collecteur il n'y a pas de contact de base proprement dit et la connection de base entre l'émetteur (20) et le contact (50) de collecteur s'effectue par du matériau de base en polysillicium.

2. Transistor bipolaire suivant la revendication 1, **caractérisé en ce que** la configuration (21) d'émetteur a deux ou plusieurs éléments (22,25,26) d'émetteur qui sont reliés entre eux.

3. Transistor bipolaire suivant la revendication 1 ou 2, **caractérisé en ce que** la configuration (21) d'émetteur a deux ou plusieurs éléments (22) d'émetteur en forme de bande qui sont dirigés parallèlement et à distance entre eux et **en ce que** les éléments (22) d'émetteur en forme de bande sont reliés entre eux à leurs extrémités (23,24) libres respectivement par un élément d'émetteur constitué sous la forme d'une barrette (25) extérieure d'émetteur.

4. Transistor bipolaire suivant la revendication 3, **caractérisé en ce qu'**entre les deux barrettes (25) extérieures d'émetteur est prévue au moins une autre barrette (26) intérieure d'émetteur reliant les deux éléments (22) d'émetteur en forme de bande et par laquelle l'espace (27) intérieur d'émetteur est subdivisé en deux ou en plusieurs sous-espaces (28).

5. Transistor bipolaire suivant la revendication 4, **caractérisé en ce qu'**un contact (41) de base est disposé dans un ou dans plusieurs des sous espaces (28).

6. Transistor bipolaire suivant l'une des revendications 1 à 5, **caractérisé en ce que** l'émetteur (20) a deux ou plusieurs configurations (21) fermées d'émetteur.

7. Transistor bipolaire suivant l'une des revendications 1 à 6, **caractérisé en ce qu'**à l'extérieur de la au moins une configuration (21) d'émetteur sont prévus au moins deux contacts (40) de base en forme de bande et/ou au moins deux contacts (50) de collecteur en forme de bande.

8. Transistor bipolaire suivant la revendication 7 dans la mesure où elle se rapporte à l'une des revendications 3 à 6, **caractérisé en ce que** les contacts (40) de base en forme de bande sont dirigés parallèlement et à distance des autres barrettes (25) d'émetteur.

9. Transistor bipolaire suivant la revendication 7, dans la mesure où elle se rapporte à l'une des revendications 3 à 6, **caractérisé en ce que** les contacts (50) de collecteur en forme de bande sont dirigés parallèlement et à distance des éléments (22) d'émetteur en forme de bande.

10. Transistor bipolaire suivant l'une des revendications 1 à 9, **caractérisé en ce qu'**au moins un émetteur (20) est raccordé dans un premier plan de métallisation ou peut l'être.

11. Transistor bipolaire suivant la revendication 10, **caractérisé en ce que** le au moins un contact (40,41) de base passe dans un deuxième plan de métallisation parallèle à la distance dans l'espace du premier plan de métallisation ou peut l'être.

12. Transistor bipolaire suivant l'une des revendications 1 à 11, **caractérisé en ce que** le polysillicium de base est réalisé sous la forme de siliciure.

13. Utilisation d'un transistor (10) bipolaire suivant l'une des revendications 1 à 12 comme transistor micro-ondes.

# FIG 1

# FIG 2

# FIG 3

FIG 4

FIG 5

## FIG 6a

## FIG 6b

EP 1 252 660 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5455186 A
- US 4680608 A

- US 5675175 A